# EUROPEAN PATENT APPLICATION

(11) **EP 4 407 668 A1**
(43) Date of publication of application: **31.07.2024**
(21) Application number: 23153758.0
(22) Date of filing: 27.01.2023
(51) Int. Cl.: H01L 21/761, H01L 21/225, H01L 21/762

(54) **SEMICONDUCTOR ARRANGEMENT WITH GUARD STRUCTURE**

(71) Applicant: Infineon Technologies Dresden GmbH & Co . KG, 01099 Dresden (DE)
(72) Inventor: HIRLER, Franz, 84424 Isen (DE); WEIS, Rolf, 01109 Dresden (DE)
(74) Representative: Westphal, Mussgnug & Partner, Patentanwälte mbB

(57) **Abstract**

A semiconductor arrangement and an electronic circuit with a semiconductor arrangement are disclosed. The semiconductor arrangement includes: a semiconductor body (100) having a first region (1) of a first doping type, a second region (2) of the first doping type, and a third region (3) of a second doping type complementary to the first doping type; and a guard structure (4) arranged in the third region (3) between the first and second regions (1, 2). The first region (1) and the second region (2) are spaced apart from each other in a lateral direction (x) of the semiconductor body (100), and the third region (3) is arranged between the first and second regions (1, 2). The guard structure (4) includes a first guard region (5) and a second guard region (6) arranged next to each other in the first lateral direction (x), wherein the first guard region (5) includes a doped region (51) of the second doping type, and wherein the second guard region (6) includes a doped region (61) of the first doping type.

## Description

This disclosure relates in general to a semiconductor arrangement with two doped regions of a first doping type that are spaced apart from each other and separated by a doped region of a second doping type complementary to the first doping type.

In this type of arrangement, the regions of the first doping type may be used to integrate various kinds of single electronic devices, such as, for example, diodes, resistors, transistors, or the like, or to integrate electronic circuits including several electronic devices. PN junctions between the regions of the first doping type and the regions of the second doping type provide for a junction isolation between the regions of the first doping type. Usually, semiconductor devices implemented in the regions of the first doping type are operated in such a way that the PN junctions between the regions of the first doping type and the region of the second doping type are reverse biased so that an injection of charge carriers from the regions of the first doping type into the region of the second doping type is prevented.

Nevertheless, operating scenarios may occur in which charge carriers are injected from the regions of the first doping type into the region of the second doping type. In this case, it is desirable to prevent the charge carriers injected by one of the regions of the first doping type from reaching the other one of the regions of the first doping type.

There is therefore a need for an efficient guard structure that is configured to prevent that charge carriers injected by one of the regions of the first doping type reach the other one of the regions of the first doping type or, at least, to reduce the number of injected charge carriers that reach the other one of the regions of the first doping type.

One example relates to a semiconductor arrangement. The semiconductor arrangement includes a semiconductor body with a first region of a first doping type, a second region of the second doping type, and a third region of a second doping type complementary to the first doping type, and a guard structure arranged in the third region between the first and second regions. The first region and the second region are spaced apart from each other in a lateral direction of the semiconductor body and the third region is arranged between the first and second regions. The guard structure includes a first guard region and a second guard region arranged next to each other in the first lateral direction, wherein the first guard region includes a doped region of the second doping type, and wherein the second guard region includes a doped region of the first doping type.

Examples are explained below with reference to the drawings. The drawings serve to illustrate certain principles, so that only aspects necessary for understanding these principles are illustrated. The drawings are not to scale. In the drawings the same reference characters denote like features.
Figures 1A and 1B illustrates one example of a semiconductor arrangement that includes first and second regions of a first doping type separated by a third region of a second doping type, and a guard structure located between the first and second regions;
Figure 2 illustrates a top view of a guard structure according to one example;
Figure 3 illustrates a top view of a guard structure according to another example;
Figure 4 illustrates an enlarged view of the guard structure according to Figure 1;
Figure 5 illustrates a modification of the guard structure according to Figure 1;
Figure 6 illustrates a semiconductor arrangement with a guard structure according to another example;
Figures 7-10 illustrate various examples of a guard structure of the type illustrated in Figure 6;
Figure 11 shows a top view of a guard structure according to another example;
Figures 12-13 illustrate different examples for connecting a guard structure of the type illustrated in Figure 8 within the semiconductor arrangement;
Figure 14-15 illustrate different examples of the first region;
Figures 16A-16F illustrate one example of a method for forming a guard structure of the type illustrated in Figure 1;
Figures 17-18 illustrate different examples of a first guard region;
Figure 19 illustrates a guard structure according to another example; and
Figures 20-21 illustrate examples of electronic circuits that include a semiconductor arrangement in accordance with any of the examples illustrated in Figures 1-19.

In the following detailed description, reference is made to the accompanying drawings. The drawings form a part of the description and for the purpose of illustration show examples of how the invention may be used and implemented. It is to be understood that the features of the various embodiments described herein may be combined with each other, unless specifically noted otherwise.

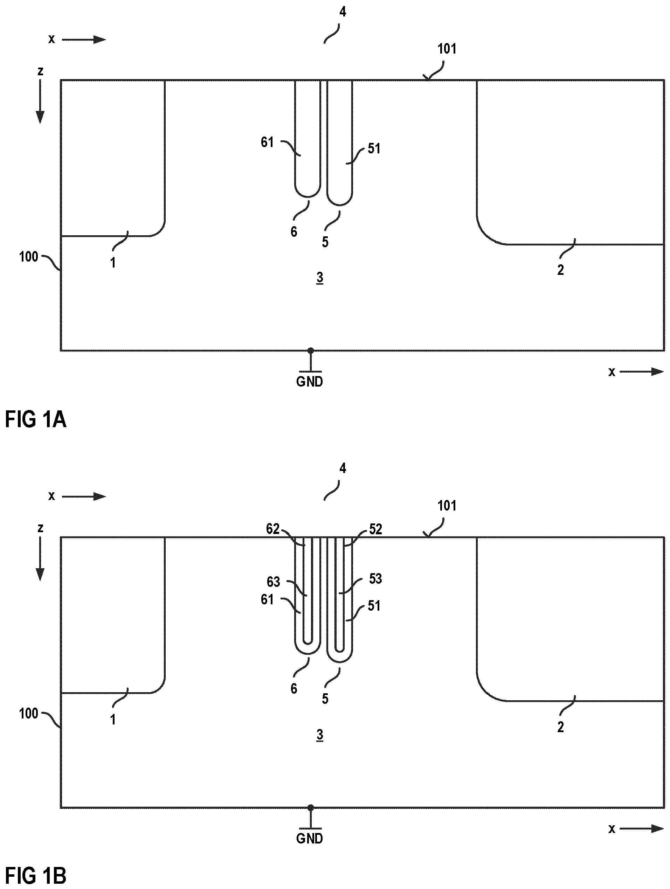

Figures 1A and 1B illustrate examples of a semiconductor arrangement. In each of these examples, the semiconductor arrangement includes a semiconductor body 100 and first and second regions 1, 2 of a first doping type arranged within the semiconductor body 100. The first and second regions 1, 2 are spaced apart from each other in a first lateral direction x of the semiconductor body 100 and are separated from each other by a third region 3 of a second doping type complementary to the first doping type. The semiconductor body 100 may include a conventional monocrystalline semiconductor material such as silicon (Si), silicon carbide (SiC), or gallium nitride (GaN).

Each of the first and second regions 1, 2 may be used to integrate one or more electronic devices, in particular, one or more semiconductor devices therein. Examples of semiconductor devices that may be integrated in the first and second regions 1, 2 are explained in detail herein further below. A PN junction is formed between the first region 1 and the third region 3 and a PN junction is formed between the second region 2 and the third region 3. These PN junction provide a junction isolation between the first region 1 and the second region 2 and, therefore, between the one or more semiconductor devices integrated in the first region 1 and the one or more semiconductor devices integrated in the second region 2.

Basically, it is desirable to operate the semiconductor devices integrated in the first and second regions 1, 2 in such a way that the PN junctions between each of the first and second regions 1, 2 and the third region 3 are reverse biased, so that charge carriers are not injected by the first and second regions 1, 2 into the third region 3. However, operating scenarios may occur in which charge carriers are injected by one of the first and second regions 1, 2 into the third region 3.

According to one example, the first and second regions 1, 2 are N-type regions and the third region 3 is a P-type region. In this example, electrons as charge carriers may be injected by one of the first and second regions 1, 2 into the third region 3 whenever an electrical potential of the respective one of the first and second regions 1, 2 becomes lower than the electrical potential of the third region 3. According to one example, the third region 3 is connected to a circuit node that is configured to be connected to the lowest electrical potential in the semiconductor arrangement, such as ground GND. In this example, charge carriers may be injected by one of the first and second regions 1, 2 when the electrical potential of the respective region becomes negative.

Charge carriers that are injected by one of the first and second regions 1, 2 into the third region 3 are minority charge carriers in the third region 3.

Charge carriers that are injected by one of the first and second regions 1, 2 into the third region 3 and that reach the other one of the first and second regions 1, 2 may negatively influence the functionality of the one or more semiconductor devices integrated in the other one of the first and second regions 1, 2 It is therefore desirable to prevent minority charge carriers injected by one of the first and second regions 1, 2 from reaching the other one of the first and second regions 1, 2 or, at least, to reduce the number of charge carriers injected by one of the first and second regions 1, 2 that reach the other one of the first and second regions 1, 2.

For this, the semiconductor arrangement includes a guard structure 4 located in the semiconductor body 100 in the third region 3 between the first and second regions 1, 2. The guard structure 4 is spaced apart from both the first region 1 and the second region 2 in the first lateral direction.

Referring to Figures 1A and 1B, the guard structure 4 includes a first guard region 5 and a second guard region 6 that both extend from a first surface 101 in a vertical direction z into the semiconductor body 100. Each of the first and second guard regions 5, 6 includes a doped region 51, 61. In the following, the doped region 51 of the first guard region 5 is also referred to as first doped region, and the doped region 61 of the second guard region 6 is also referred to as second doped region.

In the example illustrated in Figure 1A the first and second guard regions 5, 6 only include the doped regions 51, 61 that, from the first surface 101, extend into the semiconductor body 100.

In the example illustrated in Figure 1B, each of the first and second guard regions 5, 6 additionally includes a trench 52, 62 that is at least partially filled with a filling material 53, 63. Examples of the filling material 53, 63 are explained herein further below. In this example, the doped regions 51, 61 of the first and second guard regions 5, 6 adjoin the respective trench 52, 62.

According to one example, at least sidewalls of the trenches 52, 62 are covered with an insulating materials, such as an oxide. In this example, the trenches 52, 62 are isolating trenches, so that charge carriers cannot move through these trenches 52, 62 in the first lateral direction x.

The trenches 52, 62 make it possible to implement the first and second guard regions 5, 6 with a high aspect ratio and low required space. This is explained in detail herein further below. In the following, the trench 52 of the first guard region 5 is also referred to as first trench, the trench 62 of the second guard region 6 is also referred to as second trench.

The doped region 51 of the first guard region 5 is of the second doping type, which is the same doping type as the third region 3. A doping concentration of the doped region 51 of the first guard region 5, however, is higher than the doping concentration of the third region 3. The doped region 61 of the second guard region 5 is of the first doping type, which is the same doping type as the first and second regions 1, 2.

In the guard structure 4, the second guard region 6 acts as a collector that collects minority charge carriers injected by one of the first and second regions 1, 2 and, therefore, prevents the collected charge carriers from reaching the other one of the first and second regions 1, 2. More specifically, the doped region 61 of the second guard region 6 collects the minority charge carriers. The second guard region 6 is also referred to as collector region in the following.

The first guard region 5 acts as a shielding region. In the example illustrated in Figure 1, in which the first guard region 5 is arranged between the second guard region 6 and the second region 2, the first guard region 5 helps to prevent that a voltage punch-through occurs between the second region 2 and the second guard region 6, in particular, between the second region 2 and the doped region 61 of the second guard region 6.

A distance between the first and second regions 1, 2 is dependent on a maximum voltage that may occur between the first and second regions 1, 2, for example. According to one example, the semiconductor arrangement is such that the maximum voltage that may occur is in a range of between 15 V and 200 V, for example. According to one example, the distance between the first and second regions 1, 2 is selected from between several micrometers, such as 3 micrometers, and several hundred micrometers, such as 700 micrometers.

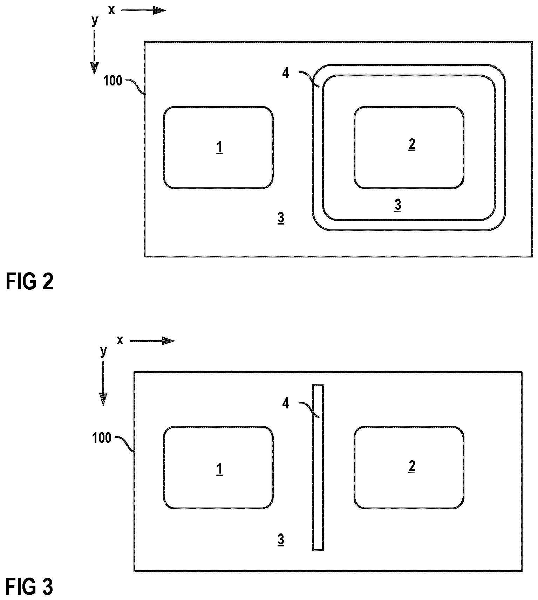

As outlined above, the guard structure 4 is arranged between the first and second regions 1, 2. In the first surface 101, the guard structure 4 may be implemented in various ways. Two examples are explained with reference to Figures 2 and 3 in the following, wherein each of Figures 2 and 3 illustrates a top view of a section of the semiconductor body 100 in which the first and second regions 1, 2 and the guard structure 4 are arranged. It should be noted that the guard structure 4 is only schematically illustrated in Figures 2 and 3. In particular, the first and second guard regions 5, 6 of the guard structure 4 are not illustrated.

Referring to Figure 2, arranging the guard structure 4 between the first and second regions 1, 2 may include that the guard structure 4, in the first surface 101 of the semiconductor body 100, forms a closed loop that surrounds one of the first and second regions 1, 2 entirely. Just for the purpose of illustration, in the example shown in Figure 2, the guard structure 4 surrounds the second region 2. According to another example (not illustrated) the guard structure 4 surrounds the first region 1.

According to another example illustrated in Figure 3, the guard structure 4, in the first surface 101 of the semiconductor body 100, forms an elongated structure that separates the first region 1 from the second region 2 but does not surround one of the first and second regions 1, 2. According to one example, the guard structure 4, in a second horizontal direction y and in a direction opposite the second horizontal direction y, extends beyond both the first region 1 and the second region 2. The "second horizontal direction y" is essentially perpendicular to the first horizontal direction x, which is the direction in which the first and second regions 1, 2 are spaced apart from each other.

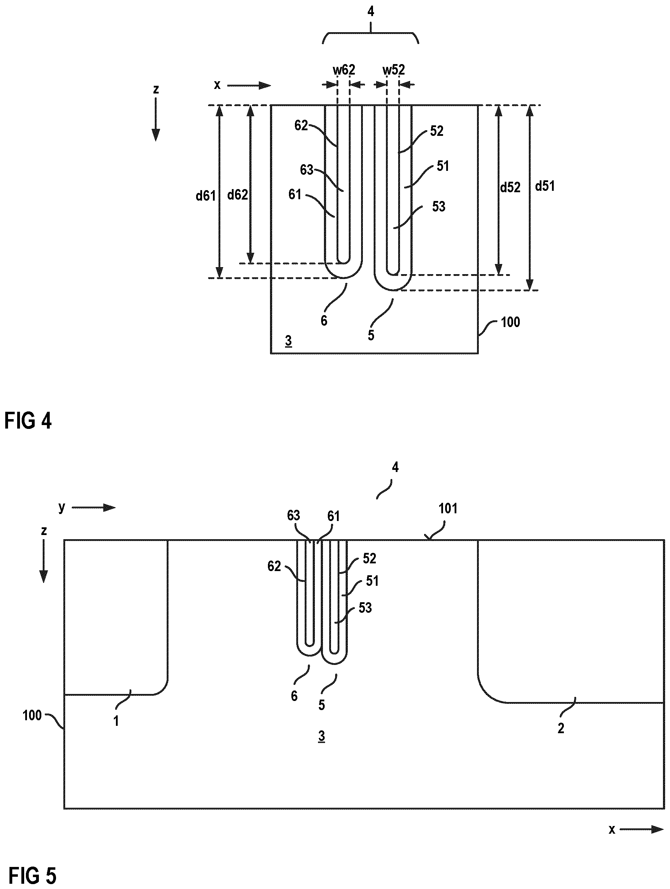

Figure 4 illustrates an example of the first and second guard regions 5, 6 in greater detail. Figure 4 illustrates an example in which these guard regions 5, 6 each include a respective trench 52, 62. However, as can be seen from Figure 1A, the trenches 52, 62 may be omitted.

Referring to Figure 4 and as outlined above, the first guard region 5 includes a first trench 52 extending from the first surface 101 into the semiconductor body 100, and the second guard region 6 includes a second trench 62 extending from the first surface 101 into the semiconductor body 100. Each of the first and second trenches 52, 62 has a respective width w52, w62, which is a dimension of the respective trench 52, 62 in the first lateral direction x. Furthermore, each of the first and second trenches 52, 62 has a respective depth d52, d62, which is a dimension of the respective trench 52, 62 in the vertical direction z. Each of the first and second trenches 52, 62 has an aspect ratio, which is a ratio between the respective depth d52, d62 and the respective width w52, w62. According to one example, each of the first and second trenches 52, 62 has an aspect ratio that is in a range of between 5 and 40 and, in particular, in a range of between 10 and 30.

According to one example, the width w52, w62 of each of the first and second trenches 52, 62 is selected from between 0.5 micrometers (µm) and 2 micrometers, and the depth d52, d62 of each of the first and second trenches 52, 62 is selected from between 5 micrometers and 20 micrometers.

Referring to Figure 4, the first trench 52 of the first guard region 5 may extend deeper into the semiconductor body 100 than the second trench 62. According to one example, the first trench 52 is between 1 and 4 micrometers deeper than the second trench 62. According to another example, the trench depth d51 of the first trench 51 is between 1.05 times and 1.3 times the trench depth of the second trench 62.

By implementing the first trench 52 such that it extends deeper into the semiconductor body 100 than the second trench 62, the first guard region 5 extends deeper into the semiconductor body 100 than the second guard region 6. This improves the capability of the first guard region 5 to provide a shield between the second guard region 6 and the second region 2.

Each of the first and second doped regions 51, 61 extends away from the respective trench 52, 62 in the semiconductor body 100. According to one example, a distance for which the first and second doped regions 51, 61 extend away from the respective trench 52, 62 is in the same range as the trench width w52, w62. Thus, according to one example, each of the doped regions 51, 61 extends away between 0.5 micrometers and 2 micrometers from the respective trench 52, 62. In this example, an overall lateral dimension of each of the first and second doped regions 51, 61 in the first lateral direction x is between 1 micrometers and 4 micrometers (2*0.5 µm and 2*2 µm). Furthermore, a lateral dimension of each of the first and second guard regions 5, 6 in the first lateral direction x is given by the respective trench width w52, w62 plus the overall lateral dimension of the respective doped region 51, 61 and is between 1.5 micrometers and 6 micrometers, for example. An overall depth of each of the first and second guard regions 5, 6 is between 5 micrometers and 22 micrometers.

In the example illustrated in Figure 1, the doped region 51 of the first guard region 5 is spaced apart from the doped region 61 of the second guard region 6. The distance is between 0.5 µm and 2 µm, for example.

This, however, is only an example. According to another example illustrated in Figure 5, the doped region 51 of the first guard region 5 adjoins the doped region 61 of the second guard region 6.

The guard structure 4 illustrated in Figure 1 is an asymmetric guard structure. That is, the guard structure 4 is configured to withstanding a higher voltage between the second region 2 and the second guard region (collector region) 6 than between the first region 1 and the second guard region 6. This is because the first guard region (shielding region) 5 is arranged between the second region 2 and the collector region 6 and there is no such shielding region between the first region 1 and the collector region 6.

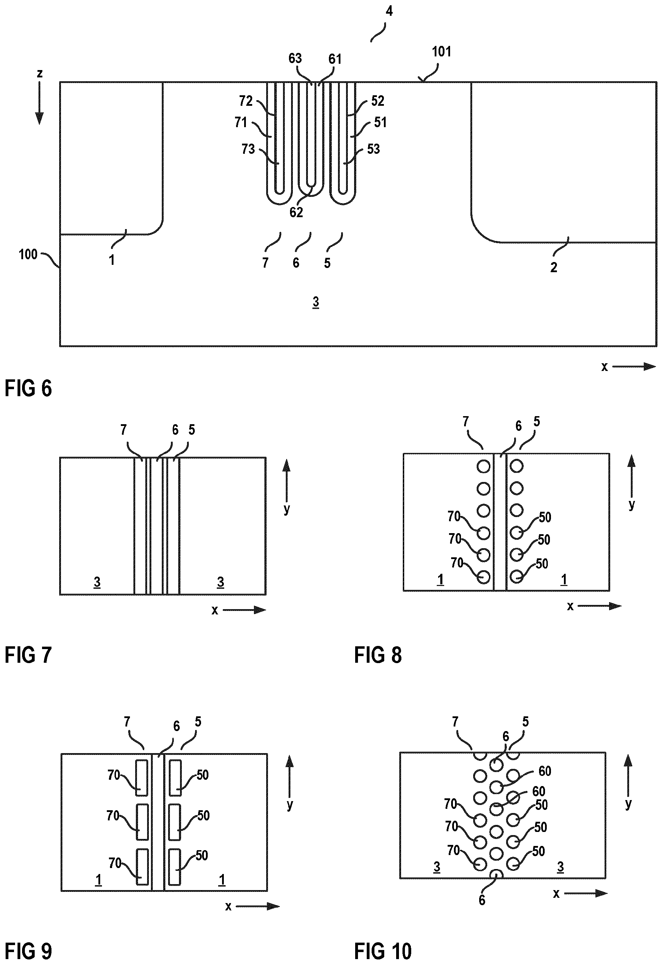

Figure 6 illustrates another example of a guard structure 4. This guard structure is based on the guard structure 4 illustrated in Figure 1 and additionally includes a third guard region 7. The third guard region 7 is arranged between the second guard region 6 and the first region 1 and extends from the first surface 101 in the vertical direction z into the semiconductor body 100. The third guard region 7 comprises a doped region 71 of the second doping type that adjoins a trench 72, wherein the trench 72 is filled with a filling material 73. In the following, the doped region 71 of the third guard region 7 is also referred to as third doped region, and the trench 72 of the third guard region 7 is also referred to as third trench. Implementing the third guard region 7 with the trench 72, however, is only an example. In the same way as illustrated with regard to the first and second guard regions 5, 6 in Figure 1A, the trench 72 of the third guard region 7 may be omitted. That is, in the guard structure 4 according to Figure 6 each of the first, second and third guard regions 5, 6, 7 may be formed without the respective trench 52, 62, 72.

According to one example, the trench 72 is an isolating trench. That is, at least sidewalls of the trench 72 are covered by an insulating material, such as an oxide. The insulating material covering the sidewalls prevents that minority charge carriers move through the trench 72 in the first lateral direction x.

Everything explained hereinabove with regard to the first guard region 5 applies to the third guard region 7 accordingly. That is, in the same way as the first guard region 5, the third guard region 7 may extend deeper into the semiconductor body 100 than the second guard region 6. Furthermore, the dimensions of the third guard region 7 may be in the same range as the dimensions of the first guard region 5.

By having the first guard region 5 arranged between the second region 2 and the second guard region 6 and by having the third guard region 7 arranged between the first region 1 and the second guard region 6, the guard structure 4 according to Figure 6 is symmetric. That is, the guard structure 4 according to Figure 6 is configured to block a voltage between the second region 2 and the second guard region 6 in the same way as a voltage between the first region 1 and the second guard region 6.

In the example illustrated in Figure 6, the first guard region 5 is spaced apart from the second guard region 6, and the third guard region 7 is spaced apart from the second guard region 6. This, however, is only an example. According to another example (not illustrated) the first and third guard regions 5, 7 may adjoin the second guard region 6 in the same way as the first guard region 1 adjoins the second guard region 6 in the example illustrated in Figure 5.

Figures 1 and 4-6 illustrate various examples of the guard structure 4 in a vertical plane of the semiconductor body 100, which is a plane that is essentially perpendicular to the first surface 101. In a horizontal plane, which is a plane that is essentially parallel to the first surface 101, the guard structure 4 may be implemented in various ways. This is explained with reference to examples illustrated in Figures 7-11 in the following. The guard structures 4 illustrated in Figures 7-11 are guard structures of the type illustrated in Figure 6, so that each guard structure 4 includes a first, a second, and a third guard region 5, 6, 7. However, everything explained in the following with regard to the guard structure 4 illustrated in Figures 7-11 applies to a structure without the third guard region 7 of the type illustrated in Figures 1 and 5 accordingly, wherein simply the third guard region 7 is to be omitted.

In each of Figures 7-11, the guard regions 5, 6, 7 are only schematically illustrated. As explained above, each of the first, second, and third guard regions 5, 6, 7 includes a respective trench 52, 62, 72 and a doped region 51, 61, 71 adjoining the trench 52, 62, 72. However, the trenches and doped regions of the guard regions 5, 6, 7 are not illustrated in Figures 7-11. Instead, only the outline of the respective guard region is illustrated. The outline of each of the guards regions 5, 6, 7 is formed by the respective doped region. That is, the outline of the first guard region 5 is formed by doped region 51, the outline of the second guard region 6 is formed by doped region 61, and the outline of the third guard region 7 is formed by doped region 71.

According to one example illustrated in Figure 7, each of the first, second, and third guard regions 5, 6, 7 is an elongated and contiguous region that longitudinally extends in the second lateral direction y. The latter is perpendicular to the first lateral direction x in which the first and second regions 1, 2 (not illustrated in Figures 7-11) are spaced apart from each other. As can be seen from Figure 6, in a guard structure 4 of the type illustrated in Figure 7, minority charge carriers that are injected by one of the first and second regions 1, 2 into the third region 3 may reach the collector region 6 only from below the collector region 6. That is, minority charge carriers collected by the collector region 6 need to move in the first lateral direction x of the semiconductor body 100 to below the collector region 6 and in the vertical direction z to the collector region 6.

Figures 8-10 illustrate examples of guard structures 4 that are more efficient than the garden structure 4 illustrated in Figure 7. In these examples, each of the first and third guard regions 5, 7 includes a plurality of partial guard regions 50, 70 that are spaced apart from each other in the second lateral direction y. According to one example, a distance between neighboring partial guard regions 50, 70 is such that minority charge carriers can move through a gap between two neighboring partial guard regions 50, 70 and reach the collector region 6. In this way, minority charge carriers injected by one of the first and second regions 1, 2 into the third region 7 can directly move in the first lateral direction x from the respective first or second region 1, 2 to the collector region 6. This significantly increases the efficiency of the guard structure 4 to collect minority charge carriers as compared to the guard structure 4 illustrated in Figure 7.

According to one example, a distance between neighboring partial guard regions 50, 70 is less than 3 micrometers, such as between 0.5 micrometers and 3 micrometers.

The partial guard regions 50, 70 may be formed by a diffusion process that includes diffusing the dopant atoms forming the first and second partial guard regions 50, 70 via the first and third trenches 52, 72 (not illustrated in Figures 8-10) into the semiconductor body 100. In this example, the doping concentration in the first and second partial guard regions 50, 70 decreases as the distance to the respective trench 52, 72 increases. In this case, it is also possible to implement the partial guard regions 50, 70 such that the partial guard regions 50, 70 overlap, so that there are continuous first and third guard regions 5, 7 with a varying doping concentration in the longitudinal direction, wherein minority charge carriers can move through the first and second guard regions in those sections with a low doping concentration.

Referring to Figures 8 and 10, the partial guard regions 50, 70 may be elliptic, such as circular, in the horizontal plane (the plane defined by the first and second lateral directions x, y). According to another example, illustrated in Figure 9, the partial guard regions 50, 70 are elongated partial guard regions. A length of these partial guard regions is between 2 micrometers and 5 micrometers, for example. In the example illustrated in Figure 9, the elongated partial guard regions 50, 70 longitudinally extend in the same direction in which the guard structure 4 longitudinally extends, which is the first lateral direction x in this example. This, however, is only an example. It is also possible that the partial guard regions 50, 70 longitudinally extend in a direction perpendicular to the longitudinal direction of the guard structure 4. That is, in the example illustrated in Figure 9 it would also be possible that the partial guard regions 50, 70 longitudinally extend in the first lateral direction x.

In the examples illustrated in Figures 8-10, the partial guard regions 50, 70 of both the first guard region 5 and the second guard region 7 are either elliptic or elongated. This, however, is only an example. It is also possible to implement the partial guard regions of one of the first and third guard regions 5, 7 as elliptic regions and to implement the partial guard regions of the other one of the first and third guard regions 5, 7 as elongated regions. It is also possible, to implement elliptic partial guard regions and elongated partial guard regions in the same first guard region 5 or third guard region 7.

Furthermore, referring to Figures 8 and 9, the second guard region 6 may be implemented as one elongated guard region. According to another example illustrated in Figure 10, the second guard region 6 may be implemented to include a plurality of partial guard regions 60 that are spaced apart from each other in the first lateral direction x. Just for the purpose of illustration, in the example illustrated in Figure 10, the partial guard regions 60 of the second guard region 6 are elliptic. According to another example (not illustrated) the partial guard regions 60 of the second guard region 6 are elongated. Everything explained hereinabove with regard to the dimensions of the partial guard regions 50, 70 and the distance between the partial guard regions 50, 70 of the first and third guard regions 5, 7 applies to the dimensions of the partial guard regions 60 and the distance between the partial guard regions 60 of the second guard region 6 accordingly.

Furthermore, in the example illustrated in Figure 10, the partial guard regions 50, 70 of the first and second guard regions 5, 7 are elliptic. This, however, is only an example. Any topology of the first and second guard regions 5, 7 explained herein before may be used in conjunction with a second guard region 6 having several partial guard regions 60.

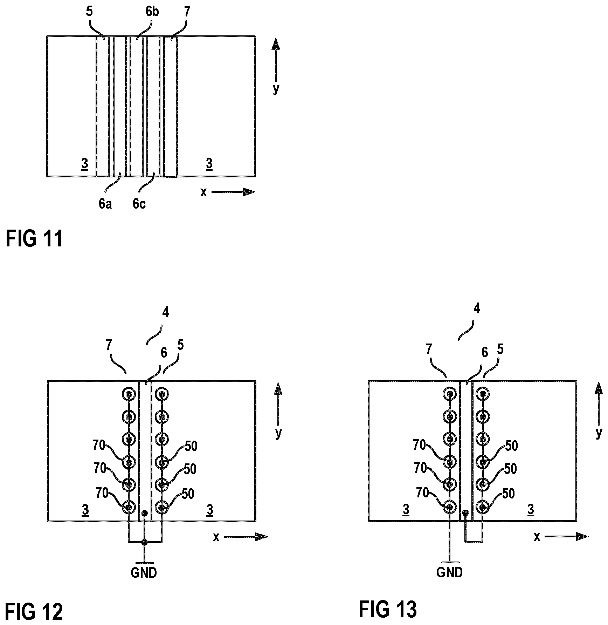

Figure 11 illustrates a modification of the guard structure 4. In this example, the guard structure 4 includes at least two second guard regions 6a, 6b, 6c that are spaced apart from each other in the first lateral direction x. Just for the purpose of illustration, the at least two second guard regions include three guard regions 6a, 6b, 6c in the example illustrated in Figure 11.

The second guard regions 6a, 6b, 6c illustrated in Figure 11 are elongated regions. This, however, is only an example. It is also possible to implement the second guard regions 6a, 6b, 6c such that at least one of these guard regions guard regions 6a, 6b, 6c includes a plurality of partial guard regions 60 that are spaced apart from each other in the second lateral direction y. In this regard, reference is made to Figure 10 and the corresponding description. Furthermore, the first and third guard regions 5, 7, which are illustrated to each include only one elongated region in the example shown in Figure 10, may also be implemented to include a plurality of partial guard regions 50, 70 in the same way as explained with reference to Figures 8-10 hereinabove. By providing at least two second guard regions, the efficiency of the guard structure 4 can be increased as compared to a structure 4 including only one second guard region 6.

In each of the examples explained above, the collector region 6 of the guard structure 4 is the collector of two parasitic bipolar transistors that each include the third region 3 as a basis. An emitter of a first one of the two parasitic bipolar transistors is formed by the first region 1, and an emitter of a second one of the two parasitic bipolar transistors is formed by the second region 2. Referring to the above, the first the guard region 5 and the optional third guard region 7 shield the collector region 6 against the first region 1 and/or the second region 2.

As explained above, the first and second regions 1, 2 may be N-type regions and the third region 3 may be a P-type region. In this example, the parasitic bipolar transistors are NPN transistors. According to another example, the first and second regions 1, 2 are P-type regions and the third region 3 is an N-type region. In this example, the parasitic bipolar transistors are PNP transistors and the minority charge carriers injected by the first and second regions 1, 2 into the third region 3 are holes.

The first, second, and third guard regions 5, 6, 7 may be electrically connected in various ways. Different examples for electrically connecting the guard regions 5, 6, 7 are explained with reference to Figures 12 and 13 in the following. Each of Figures 12 and 13 shows a top view of a guard structure 4 according to one example. Just for the purpose of illustration, the guard structure 4 illustrated in Figures 12 and 13 includes first and third guard regions 5, 7 with a plurality of partial guard regions 50, 70 and a second guard region 6 with one elongated guard region. This, however, is only an example. Everything explained in the following with regard to electrically connecting the first, second and third guard regions 5, 6, 7 applies to guard regions 5, 6, 7 with any of the topologies explained before.

According to one example illustrated in Figure 12, the first, second, and third guard regions 5, 6, 7 are connected with each other and connected to a circuit node having a predefined electrical potential. In this regard, "connecting a guard region" means connecting the respective doped to region 51, 61, 71 of the guard region 5, 6, 7. Thus, connecting the first, second, and third guard regions 5, 6, 7 with each other includes connecting the doped regions 51, 61, 71 of the guard regions 5, 6, 7 with each other.

According to one example, the circuit node having the predefined electrical potential is the same circuit node the third region 3 is connected thereto. According to another example, the first, second, and third guard regions 5, 6, 7 are connected to a circuit node having an electrical potential that is different from the electrical potential of the third region 3 during such electron injecting events. In the event that the parasitic bipolar transistors are NPN transistors, the first, second, and third guard regions 5, 6, 7 are connected to a circuit node having a lower electrical potential than the circuit node the third region 3 is connected thereto.

In the example illustrated in Figure 12, the guard structure 4 includes first and third guard regions 5, 7. According to another example (not illustrated), the third guard region 7 is omitted and the first and second guard regions 5, are electrically connected with each other and connected to the circuit node having the predefined electrical potential, which may be the same electrical potential as the electrical potential the third region 3 is connected thereto.

According to another example illustrated in Figures 13, only one of the first and third guard regions 5, 7 is connected to a circuit node having a predefined electrical potential, such as the same electrical potential as the third region 3. The other one of the first and third guard regions 5, 7 and the second guard region 6 are connected with each other and are floating. Just for the purpose of illustration, in the example illustrated in Figure 13, the third guard region 7 is connected to the circuit node having the predefined electrical potential, while the first guard region 5 is connected to the collector region 6. According to another example (not illustrated) the first guard region 5 is connected to the circuit node having the predefined electrical potential, while the third guard region 7 is connected to the collector region 6.

In the example according to Figures 13, minority charge carriers collected by the collector region 6 charge the collector region 6 and surrounding regions of the third region 3. If, for example, the minority charge carriers are electrons, the collector region 6 is negatively charged. Charging the collector region 6 and surrounding regions of the third region 3 by collected minority charge carriers changes the electrical potential of the collector region 6 in such a way that the injection of minority charge carriers by one of the first and second regions 1, 2 is reduced. Electrons, for example, negatively charge the collector region 6, so that the negative electrical potentials of the collector region 6 and of the surrounding regions of the third region 3 counteract the injection of electrons by the first and second regions 1, 2.

According to another example (not illustrated), one of the first and third guard regions 5, 7 is connected to the same circuit node as the third region 3, wherein this circuit node has a predefined electrical potential. The other one of the first and second guard regions 5, 7 and the collector region 6 are connected with each other and are connected to a circuit node having a second electrical potential different from than the first electrical potential at least dynamically during short time intervals. In this example, the second electrical potential applied to the collector region 6 and the other one of the first and second guard regions 5, 7 helps to counteract the injection of minority charge carriers. The second electrical potential is lower than the first electrical potential when the first, second, and third regions 1, 2, 3 are doped such that the minority charge carriers are electrons, and the second electrical potential is higher than the first electrical potential when the first, second, and third regions 1, 2, 3 are doped such that the minority charge carriers are holes.

According to another example (not illustrated), the first, second, and third guard regions 5, 6, 7 are connected with each other and are floating.

Referring to the above, at least one electronic device is integrated in the first or second region 1, 2. The electronic device can be any kind of active or passive electronic device. Examples of passive electronic devices include diodes and resistors. Examples of active electronic devices include transistors, such as MOSFETs (Metal Oxide Semiconductor Field-Effect Transistors), BJTs (Bipolar Junction Transistors), JFETs (Junction Field-Effect Transistors), IGBTs (Insulated Gate Bipolar Transistors), or the like.

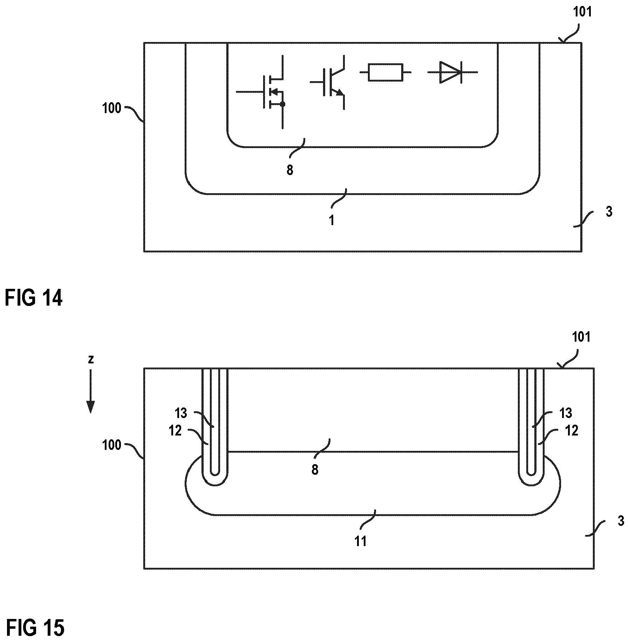

One example for integrating an electronic device in the first or second region 1, 2 is explained with reference to Figure 14 in the following. Figure 14 illustrates a vertical cross-sectional view of the first region 1. However, everything explained in the following with regard to integrating an electronic device in the first region 1 applies to integrating an electronic device in the second region 2 accordingly. In the following, "integrating an electronic device in the first or second region 1, 2" includes integrating the respective device in the first region 1 or the second region 2 of the first doping type and/or in a doped region surrounded by the first region 1 or the second region 2 in the semiconductor body 100.

In the example illustrated in Figure 14, the first region 1 of the first doping type, within the semiconductor body 100, surrounds a device region 8 of the first or second doping type. The device region 8 is arranged entirely within the first region 1, so that the device region 8 is separated from the third region 3 by the first region 1. According to one example, the at least one electronic device is integrated in the device region 8. According to another example, one or both of the device region 8 and the first region 1 form portions of the electronic device. According to one example, the electronic device is a MOSFET and the first region 1 forms one of a drain region and a source region of the MOSFET. The device region 8 may form a body region, and the other one of the drain region and the source region may be arranged within the device region 8.

Figure 15 shows one example of the first region 1 in greater detail. In this example, the first region 1, which surrounds the device region 8, includes a bottom region 11 that is spaced apart from the first surface 101 in the vertical direction, and sidewall regions 12 that extend from the first surface 101 down to or down into the bottom region 11. The bottom region 11 and the sidewall regions 12 are of the first doping type. The sidewall regions 12 surround the device region 8 in lateral directions, so that the bottom region 11 and the sidewall regions 12 form a tub-like structure around the device region 8.

According to one example, the sidewall regions 12 adjoin trenches that extend from the first surface 101 down to or down into the bottom region 11 and that are filled with a filling material 13. The sidewall regions 12 may be formed in the same way as the first, second, and third guard regions 5, 6, 7. Examples for forming these guard regions 5, 6, 7 are explained herein further below.

Forming the bottom region 11 may include implanting dopant atoms into the third region 3 and activating the implanted dopant atoms in a thermal process.

The semiconductor body 100 may be formed in various ways. According to one example, the semiconductor body 100 includes a semiconductor substrate (not illustrated in the drawings) and an epitaxial layer grown on top of the semiconductor substrate. The epitaxial layer may be grown to have a basic doping concentration, wherein a doping concentration of the third region 3 may correspond to the basic doping concentration of the epitaxial layer. According to one example, implanting the dopant atoms for forming the bottom region 11 may include implanting the dopant atoms via the first surface 101 after the epitaxial layer has been a grown to its final thickness. According to another example, the dopant atoms for forming the bottom region 11 are implanted after a first portion of the epitaxial layer has been grown that accommodates the bottom region 11. After implanting the dopant atoms for forming the bottom region 11 the epitaxial layer, in an epitaxial overgrowth process, is grown to its final thickness.

The semiconductor substrate may have the same doping type as the epitaxial layer and may have a higher doping concentration than the epitaxial layer. In the example in which the semiconductor body 100 includes a semiconductor substrate and an epitaxial layer, the third region 3 may be connected to the ground potential by connecting the semiconductor substrate to the ground potential.

According to another example, the semiconductor body 100 includes a semiconductor substrate having a basic doping concentration that corresponds to the doping concentration of the third region 3. In this example, forming the bottom region 11 may include implanting the dopant atoms via the first surface 101 into the semiconductor body 100.

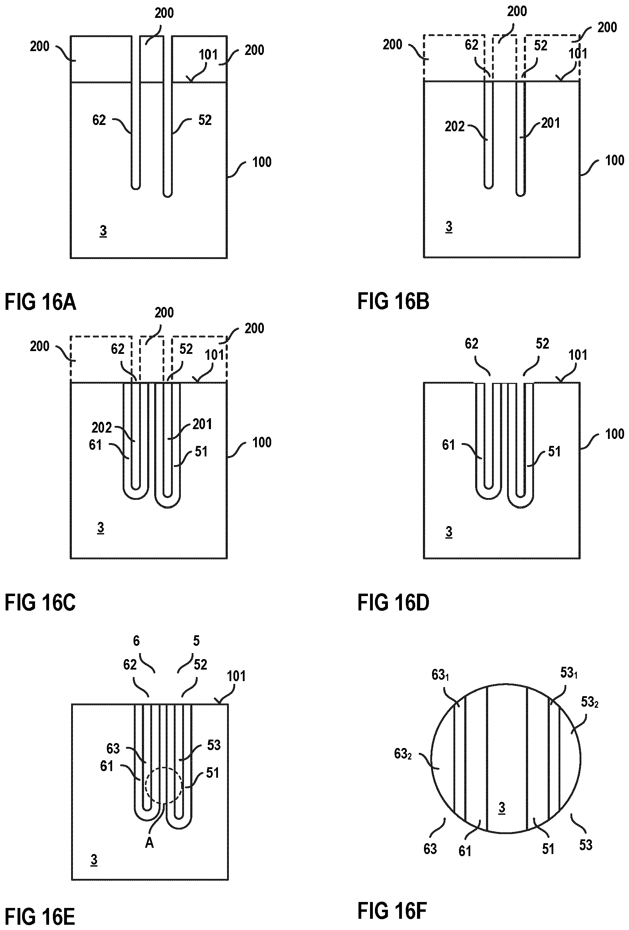

Figures 16A-16F illustrate one example of a method for forming the first and second guard regions 5, 6. The optional third guard region 7 is not illustrated in Figures 16A-16F. This third guard region 7 can be formed in the same way as the first guard region 5. Each of Figures 16A-16F shows, at different stages of the manufacturing process, a vertical cross-sectional view of one section of the semiconductor body 100 in which the guard regions 5, 6 are formed.

Referring to Figures 16A, the method includes forming the first and second trenches 52, 62 in the semiconductor body 100. Forming these trenches 52, 62 may include an anisotropic etching process using an etch mask 200 formed on top of the first surface 101. The etch mask 200 includes openings that define the position and the size of the trenches 52, 62. During the etching process, the semiconductor body 100 is etched at the bottoms of the openings in the etch mask 200.

According to one example (as illustrated in Figures 16A) the first and second trenches 52, 62 are etched at the same time by the same etching process. Referring to the above, the first trench 52 may extend deeper into the semiconductor body 100 then the second trend 62. This may be achieved in the same etching process by forming the first trench 52 wider than the second trench 62. Forming differently deep trenches by the same etching process is known, so that no further explanation is required in this regard.

Referring to Figures 16B, the method further includes forming a first dopant source 201 in the first trench 52 and a second dopant source 202 in the second trench 62. The first dopant source 201 includes dopant atoms of the second doping type, and the second dopant source 202 includes dopant atoms of the first doping type that. According to one example, the first dopant source 201 includes BSG (borosilicate glass) and the second dopant source 202 includes PSG (phosphosilicate glass). BSG includes boron atoms, which are P-type dopant atoms (in silicon), and PSG includes phosphorous atoms, which are N-type dopant atoms (in silicon).

During the process of forming the first and second doping sources 201, 202 the etch mask 200 may remain on top of the first surface 101. This is illustrated in dashed lines in Figure 16B. The etch mask 200 protects the regions below the first surface 101 from being contaminated by the materials forming the first and second dopant sources 201, 202.

Forming the first and second dopant sources 201 202 may include, as illustrated in Figures 16B, forming the first and second dopant sources 201, 202 such that each of these dopant sources 201, 202 entirely fills the respective trench 52, 62. According to another example, the first and second dopant sources 21, 202 are formed such that they cover (line) sidewalls and bottoms of the trenches 52, 62 but do not entirely fill the trenches 52, 62. Lining the bottoms and the sidewalls of the trenches 52, 62 instead of entirely filling the trenches reduces stress in the semiconductor body 100 that is associated with forming the first and second dopant sources 201, 202.

Forming the dopant source 201 in the first trench 52 and the second dopant source 202 in the second trench 62 may include forming the first dopant source 201 in both trenches 52, 62, removing the first dopant source 201 from the second trench 62, and forming the second dopant source 202 in the second trench 62. Of course, the order in which the first and second dopant sources 201, 202 are formed can be changed. According to another example, when forming the first dopant source 201, a protection layer is formed on top of the second trench 62 that prevents the first dopant source 201 from being formed in the second trench 62. After forming the first open source 201 the protection layer is removed and the second dopant source 202 is formed in the second trench 62. Of course, the order can be changed, so that the second dopant source 22 is formed first, wherein the first trench 52 is protected by a protection layer when the second dopant source 202 is formed.

Forming each of the first and second dopant sources 21, 22 may include depositing a respective dopant source layer in the respective trench. Referring to the above, the dopant source layer may be formed such that it entirely fills the respective trench 52, 62 or only lines the bottom and the sidewalls of the respective trench to form their respective dopant source 201, 202. Depositing the dopant source layer may include depositing the dopant source layer also on top of the first surface 101 of the semiconductor body 100 or on top of the etch mask 200 (illustrated in dashed lines in Figure 16B). In the first case, the dopant source layer is to be removed from the first surface 101 before the thermal process explained with reference to Figure 16C in the following in order to avoid dopant atoms from diffusing into the first surface 101. In the second case, the dopant source layer may remain on top of the etch mask 200 during the thermal process explained with reference to Figure 16C in the following.

Referring to Figures 16C, the method further includes a thermal process in which first type dopant atoms are diffused from the first dopant source 201 into the semiconductor body 100 to form the first doped region 51 and second type dopant atoms are diffused from the second dopant source 202 into the semiconductor body 100 to form the second doped region 61. How deep the dopant atoms diffuse into the semiconductor body 100 from their respective dopant source 21, 22 is dependent on the temperature and the duration of the thermal process, for example. Basically, the higher the temperature and the longer the thermal process the deeper the dopant atoms diffuse into the semiconductor body 100. Thus, the size of the doped regions 51, 61 can be adjusted by suitably adjusting the process parameters (temperature and duration) in the thermal process.

The temperature in the thermal process is selected from between 900 °C and 1100 °C, for example. The duration of the thermal process is selected from between 20 minutes and 300 minutes, for example.

Only one thermal process, such as the thermal process illustrated in Figure 16C, may be used to diffuse dopant atoms from both the first dopant source 201 and the second dopant source 202 into the semiconductor body 100. According to another example, dopant atoms from that dopant source that is produced first in the process explained with reference to Figure 16B may be diffused into the semiconductor body 100 in a first thermal process before forming the other one of the dopant sources 201, 202. If, for example, the first dopant source 201 is formed first in the process according to Figure 16B, dopant atoms may be diffused into the semiconductor body 100 from the first dopant source 201 before forming the second dopant source 202. In the thermal process illustrated in Figure 16C, that takes place after both dopant sources 201, 202 have been formed, dopant atoms are then diffused from both the first dopant source 201 and the second dopant source 202 into the semiconductor body 100.

Referring to Figures 16D, the method further includes removing the first and second dopant sources 201, 202 from the first and second trenches 52, 62 after the diffusion process. Removing the first and second dopant resources 201, 202 may include an etching process that etches the dopant sources 201, 202 selectively relative to the semiconductor body 100. In the event that the etch mask 200 is in place during the thermal process, removing the first and second dopant sources 21, 22 from the trenches 52, 62 also includes removing the etch mask 200.

Referring to Figures 16E the method further includes filling the trenches with the respective filling material 53, 63. Although Figures 16E shows an example in which the first and second trenches 52, 62 have been filled completely, "filling the trenches" as used herein not necessarily includes filling the trenches completely. Instead, "filling the trenches" includes at least covering the sidewalls and the trenches 52, 62 by a respective filling material.

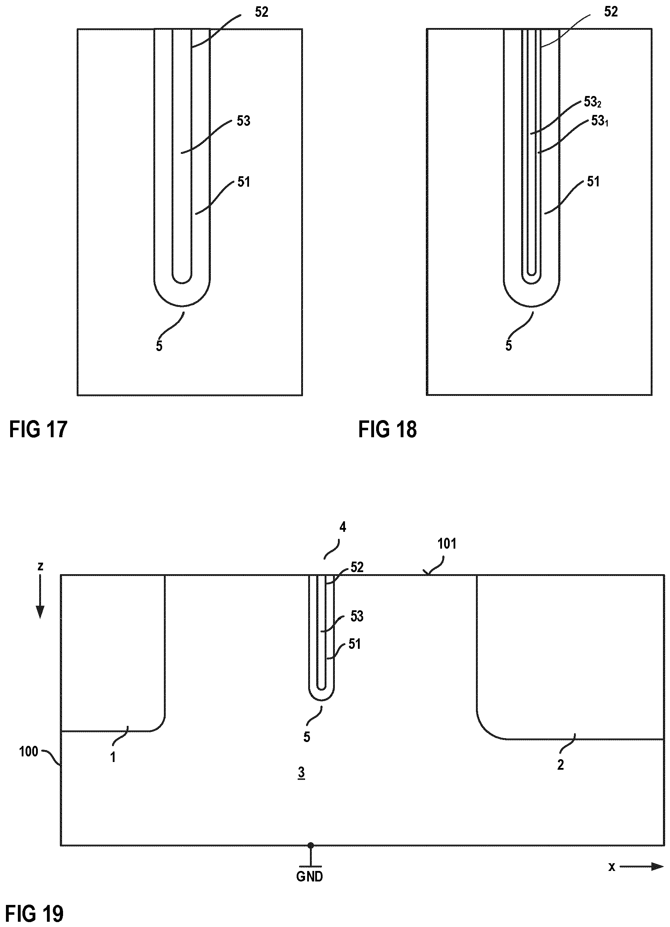

According to one example, the filling material 53, 63 is a homogeneous material such as, for example, an oxide or a nitride. An example of a homogeneous filling material is illustrated in Figure 17. Just for the purpose of illustration, the filling material illustrated in Figure 17 is the filling material 53 of the first guard region 5. This, however, is only an example. The filling material 62 of the second guard region 6 may be implemented in the same way.

According to another example at least one of the first and second filling materials 53, 63 includes at least two different material layers. This is illustrated in in Figures 16F and 18. Figure 16F which shows a detail A of the arrangement shown in Figure 16E, and Figure 18 shows one example of the first guard region 5, wherein the filling material 53 includes two different material layers 53₁, 53₂. Just for the purpose of illustration, in the example shown in Figure 16F, each of the first and second filling material 53, 63 includes two different material layers.

According to one example, a first material layer 53₁, 63₁ is an insulating layer. According to one example, the insulating layer is deposited at least on sidewalls of the trenches 52, 62. According to another example, the insulating layer is deposited on sidewalls and bottoms of the trenches. According to yet another example, the insulating layer is an oxide layer that is thermally grown on the sidewalls and the bottom of the trenches 52, 62. Forming this first material 53₁, 63₁ layer may include a thermal oxidation process after removing the respective dopant source 201, 202 from the respective trench 52, 62.

The second material layer 53₂, 63₂ is an insulating layer, such as an oxide layer or a nitride layer. According to another example, the second material layer 53₂, 63₂ is an electrically conducting layer or a semiconducting layer. The electrically conducting layer is a doped polysilicon layer, for example. The semiconducting layer is a non-doped polysilicon layer, for example.

The second material layer 53₂, 63₂ is deposited in the respective trench 52, 62 after forming the first material layer 53₁, 63₁. The second material layer 53₂, 63₂ may be formed either such that it entirely fills the residual trench that remains after forming the first material layer 53₁, 63₁, or such that it covers the first material layer 53₁, 63₁ but does not entirely fill the residual trench (so that a further residual trench remains).

Referring to the above, the sidewall region 12 adjoining the trench with the filling material 13 of the first region 1 according to Figure 15 may be formed in the same way as the first and second guard regions 5, 6. That is, after forming a trench that defines the size of the device region 8, a dopant source may be formed in the trench and dopant atoms may be diffused from the dopant source into the semiconductor body, wherein these dopant atoms are activated by a thermal process in order to form the dopant sidewall region 12.

Forming the guard regions 5, 6, 7 without the trenches 52, 62, 72, may include implanting and/or diffusing the respective dopant atoms via the first surface 101 into the semiconductor body 100 to form the first, second, and third doped regions 51, 61, 71.

Figure 19 illustrates a modification of the guard structure 4 explained herein before. The guard structure 4 illustrated in Figure 19 is different from the guard structures 4 explained herein before in that it only includes the first guard region 5 with the first doped region 51 and the first trench 52 filled with the filling material 53. Everything explained with regard to the first guard structure 5 herein before applies to the first guard structure 5 in Figure 19 accordingly. Furthermore, everything explained hereinabove with regard to the topology of the guard structure 4 and the distance between the guard structure 4 and the first and second regions 1, 2 applies to the guard structure 4 according to Figure 19 accordingly. The guard structure 4, does not collect minority charge carriers injected by 1 of the first and second regions 1, 2 into the third region 3. Instead, the guard structure 4 essentially provides a shield for minority charge carriers moving between the first and second regions 1, 2.

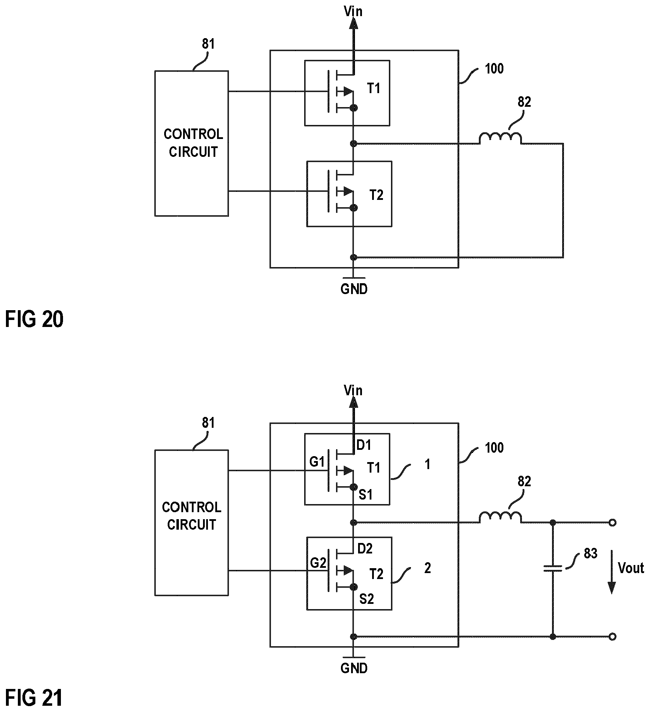

Figures 20 and 21 illustrate examples of electronic circuits that include a semiconductor arrangement in accordance with any one of the examples explained herein above. Each of the electronic circuits illustrated in Figures 20 and 21 includes a first transistor device T1 and a second transistor device T2 that are connected in series between first and second supply nodes, so that an input voltage Vin is available across the transistor series circuit. According to one example, the input voltage Vin is referenced to ground GND. The first and second transistor devices T1, T2 being connected in series includes that load paths of the first and second transistor devices T1, T2 are connected in series. According to one example (as illustrated in Figures 20 and 21) the transistor devices T1, T2 our MOSFETs. In this example, a load path of the first transistor device T1 is between a first drain node D1 and a first source node S1, and a load path of the second transistor devices T2 is between a second drain node D2 and a second source node S2.

Each of the first and second transistor devices T1, T2 is controlled by a control circuit 81 that is configured to switch on or off each of the first and second transistor devices T1, T2. For this, the control circuit 81 is connected to a drive node of each of the first and second transistor devices T1, T2. In the example illustrated in Figures 20 and 21, in which the transistor devices T1, T2 are MOSFETs, drive nodes of the first transistor devices are gate nodes G1, G2 of the MOSFETs.

Referring to Figures 20 and 21, an inductive element 82 is connected in parallel with the load path of the second transistor device T2. Referring to Figure 20, this may include that only the inductive element 82 is connected in parallel with the load path of the second transistor device T2. The inductive element 82 may be part of a motor, of a magnetic valve, a transformer, a loudspeaker, a coil, or the like.

Referring to Figure 21, and inductive element 82 being connected in parallel with the load path of the second transistor device T2 may also include that a series circuit including the inductive element 82 and at least one further second element is connected in series with the load path of the second transistor device T2. In the example illustrated in Figure 21, the electronic circuit is a buck converter that is configured to generate an output voltage Vout based on the input voltage Vin. The circuit element 83 connected in series with the inductive element 82 is a capacitor in this example, wherein the output voltage Vout is available across the capacitor 83.

In the following, "series circuit including the inductive element 82" includes a second path with the inductive element 82 and with or without an additional circuit element.

In each of the electronic circuits illustrated in Figures 20 and 21, the first transistor device T1 is integrated in the first region 1 of the semiconductor body 100, and the second transistor device T2 is integrated in the second region 2 of the semiconductor body 100. The semiconductor body 100 and the first and second regions 1, 2 are only schematically illustrated in Figures 20 and 21. Further elements of the semiconductor body 100, in particular, the guard structure 4 are not illustrated. The semiconductor body 100 and the guard structure 4 may be implemented in accordance with any of the examples explained herein before.

According to one example, the control circuit 81 is integrated in the semiconductor body 100. For this, the semiconductor body 100 may include one or more additional regions of the first doping type arranged in the third region 3, wherein the control circuit 81 is integrated in the one or more additional regions of the first doping type.

Each of the electronic circuits illustrated in Figures 20 and 21 may the operated in such a way that the control circuit 81 alternatingly switches on and off the first and second transistor devices T1, T2 such that only one of the first and second transistor devices T1, T2 is switched on at the same time. In those time periods in which the first transistor device T1 is switched on, the voltage across the load path of the second transistor device T2 and, therefore, the voltage across the series circuit including the inductive element 82 essentially equals the input voltage Vin. After the first transistor device T1 has been switched off, the inductive element 82 drives a current through the second transistor devices T2. The current through the second transistor device T2 causes a voltage drop across the second transistor device T2, so that an electrical potential at the circuit node where the load paths of the first and second transistor devices T1, T2 are connected may (slightly) fall below ground potential GND.

According to one example, the first and second transistor devices T1, T2 are connected in series such that the source node S1 of the first transistor device T1 and the drain node D2 of the second transistor device T2 are connected. Furthermore, the drain node D1 of the first transistor device T1 is connected to the first region 1, and the drain node D2 of the second transistor device T2 is connected to the second region 2. In this example, minority charge carriers may be injected by the second region 2 into the third region 3 (not illustrated in Figures 20 and 21) when the electrical potential at the drain node D2 of the second transistor device T2 falls below ground potential GND. The guard structure 4 (not illustrated in Figures 20 and 21) prevents that minority charge carriers reach the first region 1 or, at least, reduces the number of minority charge carriers that reach the first region 1.

According to another example (not illustrated) the second transistor device T2 is replaced by a freewheeling diode that has its anode connected to the ground node and its cathode connected to the source S1 of the first transistor device T 1. This freewheeling diodes conducts and takes over the current through the inductor 82 current whenever the first transistor device T1 switches off, wherein the conducting freewheeling diode may cause the electrical potential at the source node S1 of the first transistor device T1 to fall below ground potential GND.

Some of the aspects explained hereinabove are briefly summarized in the following with reference to numbered examples.
Example 1. A semiconductor arrangement, including: a semiconductor body including a first region of a first doping type, a second region of the first doping type, and a third region of a second doping type complementary to the first doping type; and a guard structure arranged in the third region between the first and second regions, wherein the first region and the second region are spaced apart from each other in a lateral direction of the semiconductor body, and wherein the third region is arranged between the first and second regions, wherein the guard structure includes a first guard region and a second guard region arranged next to each other in the first lateral direction, wherein the first guard region includes a doped region of the second doping type, and wherein the second guard region includes a doped region of the first doping type.
Example 2. The semiconductor arrangement of example 1, wherein the doped region of the second doping type of the first guard region adjoins a first trench, and wherein the doped region of the first to doping type of the second guard region adjoins a second trench.
Example 3. The semiconductor arrangement of example 1 or 2, wherein each of the first and second guard regions extends from a first surface into the semiconductor body, and wherein the first guard region extends deeper into the semiconductor body than the second guard region.
Example 4. The semiconductor arrangement of any one of examples 1 to 3, wherein the guard structure further includes a third guard region, wherein the third guard region includes a doped region of the second doping type adjoining a third trench, and wherein the second guard region is arranged between the first and third guard regions.
Example 5. The semiconductor arrangement of example 4, wherein the third guard region extends deeper into the semiconductor body than the second guard region.
Example 6. The semiconductor arrangement of any one of the preceding examples, wherein the first guard region includes a plurality of partial guard regions that are spaced apart from each other in a second lateral direction different from the first lateral direction.
Example 7. The semiconductor arrangement of example 6, wherein a distance between neighboring partial guard regions of the first guard region is less than 3 micrometers.
Example 8. The semiconductor arrangement of any one of the preceding examples, wherein the second guard region includes a plurality of partial guard regions that are spaced apart from each other in a second lateral direction different from the first lateral direction.
Example 9. The semiconductor arrangement of example 8, wherein a distance between neighboring partial guard regions of the second guard region is less than 3 micrometers.
Example 10. The semiconductor arrangement of any one of examples 4 to 9, wherein the third guard region includes a plurality of partial guard regions that are spaced apart from each other in a second lateral direction different from the first lateral direction.
Example 11. The semiconductor arrangement of any one of the preceding examples, wherein at least one of the first, second, and third trenches includes an insulation layer covering sidewalls of the respective trench the respective doped region adjoining the respective trench.
Example 12. The semiconductor arrangement of example 10, wherein the insulation layer entirely fills the respective trench.
Example 13. The semiconductor arrangement of example 10, wherein the insulation layer forms a residual trench that is filled with an electrically conducting material.
Example 14. The semiconductor arrangement of any one of examples 4 to 13, wherein the third region is connected to a circuit node that is configured to receive a predefined electrical potential.
Example 15. The semiconductor arrangement of example 14, wherein the respective doped region of each of the first, second, and third guard regions is connected to a circuit node that is configured to receive the predefined electrical potential.
Example 16. The semiconductor arrangement of example 14, wherein the doped region of one of the first and third guard regions is connected to a second node that is configured to receive the predefined electrical potential, and wherein the doped region of the other one of the first and third guard regions is connected to the doped region of the second guard region.
Example 17. The semiconductor arrangement of any one of the preceding examples, wherein at least one semiconductor device is integrated in each of the first and second regions.
Example 18. The semiconductor arrangement of any one of the preceding examples, wherein an aspect ratio of each of the first and second trenches is between 5 and 30.
Example 19. The semiconductor arrangement of any one of the preceding examples, wherein the guard structure surrounds one of the first and second regions in lateral directions of the semiconductor body.
Example 20. A semiconductor arrangement, including: a semiconductor body including a first region of a first doping type, a second region of the second doping type, and a third region of a second doping type complementary to the first doping type; and a guard structure arranged in the third region between the first and second regions, wherein the first region and the second region are spaced apart from each other in a lateral direction of the semiconductor body, and wherein the third region is arranged between the first and second regions, wherein the guard structure includes a first guard region, wherein the first guard region includes a doped region of the second doping type adjoining a first trench, and wherein an aspect ratio of the trench is higher than 5.
Example 21. An electronic circuit, including: a semiconductor arrangement according to any one of examples 1 to 20; a first transistor device and a second transistor devices, wherein a load path of the first transistor device is connected in series with a load path of the second transistor device, wherein the first transistor device is integrated in the first region of the semiconductor arrangement, and wherein the second transistor device is integrated in the second region of the semiconductor arrangement.
Example 22. The electronic circuit according to example 21, further including: a circuit path including an inductive element, wherein the circuit path is connected in parallel with a load path of the second transistor device.

## Claims

1. A semiconductor arrangement, comprising:
a semiconductor body (100) comprising a first region (1) of a first doping type, a second region (2) of the first doping type, and a third region (3) of a second doping type complementary to the first doping type; and
a guard structure (4) arranged in the third region (3) between the first and second regions (1, 2),
wherein the first region (1) and the second region (2) are spaced apart from each other in a lateral direction (x) of the semiconductor body (100), and wherein the third region (3) is arranged between the first and second regions (1, 2),
wherein the guard structure (4) comprises a first guard region (5) and a second guard region (6) arranged next to each other in the first lateral direction (x),
wherein the first guard region (5) comprises a doped region (51) of the second doping type, and
wherein the second guard region (6) comprises a doped region (61) of the first doping type.

2. The semiconductor arrangement of claim 1,
wherein the doped region (51) of the second doping type of the first guard region (5) adjoins a first trench (52), and
wherein the doped region (61) of the first to doping type of the second guard region (6) adjoins a second trench (62).

3. The semiconductor arrangement of claim 1 or 2,
wherein each of the first and second guard regions (5, 6) extends from a first surface (101) into the semiconductor body (100), and
wherein the first guard region (5) extends deeper into the semiconductor body (100) than the second guard region (6).

4. The semiconductor arrangement of any one of claims 1 to 3,
wherein the guard structure (4) further comprises a third guard region (7),
wherein the third guard region (7) comprises a doped region (71) of the second doping type adjoining a third trench (72), and
wherein the second guard region (6) is arranged between the first and third guard regions (5, 7).

5. The semiconductor arrangement of claim 4,
wherein the third guard region (7) extends deeper into the semiconductor body (100) than the second guard region (6).

6. The semiconductor arrangement of any one of the preceding claims,
wherein the first guard region (5) comprises a plurality of partial guard regions (50) that are spaced apart from each other in a second lateral direction (y) different from the first lateral direction (x).

7. The semiconductor arrangement of any one of the preceding claims,
wherein the second guard region (6) comprises a plurality of partial guard regions (60) that are spaced apart from each other in a second lateral direction (y) different from the first lateral direction (x).

8. The semiconductor arrangement of any one of claims 4 to 7,
wherein the third guard region (7) comprises a plurality of partial guard regions (70) that are spaced apart from each other in a second lateral direction (y) different from the first lateral direction (x).

9. The semiconductor arrangement of any one of the preceding claims,
wherein at least one of the first, second, and third trenches (52, 62, 72) comprises an insulation layer covering sidewalls of the respective trench (52, 62, 72) the respective doped region adjoining the respective trench (52, 62, 72).

10. The semiconductor arrangement of any one of claims 4 to 9,
wherein the third region (3) is connected to a circuit node that is configured to receive a predefined electrical potential (GND).

11. The semiconductor arrangement of claim 10,
wherein the respective doped region (51, 61, 71) of each of the first, second, and third guard regions (5, 6, 7) is connected to a circuit node that is configured to receive the predefined electrical potential (GND).

12. The semiconductor arrangement of claim 10,
wherein the doped region (51, 71) of one of the first and third guard regions (5, 7) is connected to a second node that is configured to receive the predefined electrical potential (GND), and
wherein the doped region (51, 71) of the other one of the first and third guard regions (5, 7) is connected to the doped region (61) of the second guard region (6).

13. The semiconductor arrangement of any one of the preceding claims,
wherein at least one semiconductor device is integrated in each of the first and second regions (1, 2).

14. A semiconductor arrangement, comprising:
a semiconductor body (100) comprising a first region (1) of a first doping type, a second region (2) of the second doping type, and a third region (3) of a second doping type complementary to the first doping type; and
a guard structure (4) arranged in the third region (3) between the first and second regions (1, 2),
wherein the first region (1) and the second region (2) are spaced apart from each other in a lateral direction (x) of the semiconductor body (100), and wherein the third region (3) is arranged between the first and second regions (1, 2),
wherein the guard structure (4) comprises a first guard region (5),
wherein the first guard region (5) comprises a doped region (51) of the second doping type adjoining a first trench (52), and
wherein an aspect ratio of the trench (52) is higher than 5.

15. An electronic circuit, comprising:
a semiconductor arrangement according to any one of claims 1 to 20;
a first transistor device (T1) and a second transistor devices (T2),
wherein a load path of the first transistor device (T1) is connected in series with a load path of the second transistor device (T2),
wherein the first transistor device (T1) is integrated in the first region (1) of the semiconductor arrangement, and
wherein the second transistor device (T2) is integrated in the second region (2) of the semiconductor arrangement.
